(19) Europäisches Patentamt
European Patent Office
Office européen des brevets

(11) **EP 3 843 277 A1**

(12) **DEMANDE DE BREVET EUROPEEN**

(43) Date de publication:
**30.06.2021 Bulletin 2021/26**

(51) Int Cl.:
***H03M 3/00*** (2006.01)

(21) Numéro de dépôt: **20216583.3**

(22) Date de dépôt: **22.12.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
**KH MA MD TN**

(30) Priorité: **26.12.2019 FR 1915610**

(71) Demandeur: **THALES**
**92400 Courbevoie (FR)**

(72) Inventeurs:
• **AKBARI, Masoume**
**MONTREAL, Québec H3T 1J4 (CA)**
• **SAWAN, Mohamad**
**MONTREAL, Québec H3T 1J4 (CA)**

(74) Mandataire: **Lavoix**
**2, place d'Estienne d'Orves**
**75441 Paris Cedex 09 (FR)**

(54) **DISPOSITIF DE CONVERSION ANALOGIQUE-NUMÉRIQUE COMPRENANT DEUX ÉTAGES CASCADÉS DE CONVERSION ANALOGIQUE-NUMÉRIQUE AVEC REGISTRE À APPROXIMATIONS SUCCESSIVES ET MISE EN FORME DU BRUIT, ET CAPTEUR ÉLECTRONIQUE ASSOCIÉ**

(57) Ce dispositif de conversion analogique-numérique (10) comprend :
- une borne d'entrée (12) pour recevoir un signal d'entrée analogique ($V_{in}(z)$) ;
- une borne de sortie (14) pour délivrer un signal de sortie numérique ($D_{out}(z)$) ;
- un premier module (24) de conversion analogique-numérique avec registre à approximations successives, dit premier module SAR ADC, connecté à la borne d'entrée (12) ;
- un premier module de rétroaction (30) associé au premier module SAR ADC (24) ;
- un deuxième module (38) de conversion analogique-numérique avec registre à approximations successives, dit deuxième module SAR ADC, connecté en cascade au premier module SAR ADC (24) ;
- un deuxième module de rétroaction (44) associé au deuxième module SAR ADC (38) ; et
- un module de multiplexage (20) connecté aux premier et deuxième modules SAR ADC (24, 38), pour délivrer le signal de sortie numérique ($D_{out}(z)$).

FIG.1

**Description**

La présente invention concerne un dispositif de conversion analogique-numérique pour convertir un signal d'entrée analogique en un signal de sortie numérique.

L'invention concerne également un capteur électronique comprenant un tel dispositif de conversion analogique-numérique.

Cette invention concerne le domaine des convertisseurs analogiques-numériques, également appelés ADC (de l'anglais *Analog-to-Digital Converter*), en particulier dans les systèmes d'acquisition de données à haute densité de canaux. Ces convertisseurs analogique-numérique sont généralement utilisés dans des applications biomédicales et d'instrumentation.

Les convertisseurs analogique-numérique avec registre à approximations successives, également appelés SAR ADC (de l'anglais *Successive Approximation Register Analog-to-Digital Converter*), sont populaires dans les systèmes multiplexés en raison de leur faible latence et de leur réponse rapide, même pour les signaux d'entrée à pleine échelle sans aucun problème de stabilisation, comme l'explique l'article « Demystifying High-Performance Multiplexed Data-Acquisition Systems » de M. Pachchigar, dans Analog Dialogue, 2014. Les convertisseurs analogique-numérique avec registre à approximations successives ont été largement utilisés dans les applications à haute efficacité énergétique en raison de leur simplicité et de leur efficacité énergétique.

Un convertisseur analogique-numérique avec registre à approximations successives comprend typiquement un convertisseur numérique-analogique, également noté DAC (de l'anglais *Digital-to- Analog Converter*), avec une entrée et une sortie ; un comparateur avec deux entrées et une sortie, une entrée étant connectée à la sortie du convertisseur numérique-analogique et l'autre entrée étant adaptée pour recevoir un signal de référence ; et une unité logique avec registre à approximations successives connectée à la sortie du comparateur, l'unité logique avec registre à approximations successives étant adaptée pour commander le convertisseur numérique-analogique. Le convertisseur numérique-analogique contient généralement un réseau de condensateurs (de l'anglais *capacitor array*), également appelé peigne de condensateurs.

US 2018/0183450 A1 concerne un convertisseur analogique-numérique à approximations successives entrelacées avec mise en forme du bruit (de l'anglais *noise shaping*) ayant un premier bloc avec registre à approximations successives, également appelé premier bloc SAR, un deuxième bloc avec registre à approximations successives, également appelé deuxième bloc SAR, et un circuit de mise en forme du bruit. Les premier et deuxième blocs SAR échantillonnent à tour de rôle une tension d'entrée pour une approximation successive de la tension d'entrée et l'observation d'une représentation numérique de la tension d'entrée. Le circuit de mise en forme du bruit reçoit une première tension résiduelle du premier bloc SAR et reçoit une deuxième tension résiduelle du deuxième bloc SAR en alternance, et émet un signal de mise en forme du bruit à injecter dans le premier bloc SAR et le deuxième bloc SAR. Un tel convertisseur analogique-numérique avec registre à approximations successives permet d'augmenter la vitesse du processus, car lorsqu'un bloc SAR est en mode conversion, l'autre échantillonne l'entrée suivante.

Cependant, les convertisseurs analogique-numérique avec registre à approximations successives souffrent d'un bruit significatif du comparateur, ainsi que de l'énergie supplémentaire nécessaire pour piloter un grand réseau de condensateurs du convertisseur numérique-analogique. Par conséquent, ces convertisseurs analogique-numérique avec registre à approximations successives sont rarement utilisés pour des applications de résolution supérieure à 10 bits ou 12 bits.

Le but de l'invention est donc de proposer un dispositif de conversion analogique-numérique amélioré comprenant au moins un convertisseur analogique-numérique avec registre à approximations successives.

A cet effet, l'invention a pour objet un dispositif de conversion analogique-numérique pour convertir un signal d'entrée analogique en un signal de sortie numérique, comprenant :

- une borne d'entrée pour recevoir le signal d'entrée analogique ;
- une borne de sortie pour délivrer le signal de sortie numérique ;
- un premier module de conversion analogique-numérique avec registre à approximations successives, dit premier module SAR ADC, connecté via son entrée à la borne d'entrée et configuré pour délivrer via sa sortie un premier signal numérique ;
- un premier module de rétroaction configuré pour recevoir un premier signal résiduel du premier module SAR ADC et pour le traiter et le réinjecter à l'entrée du premier module SAR ADC ;
- un deuxième module de conversion analogique-numérique avec registre à approximations successives, dit deuxième module SAR ADC, connecté par son entrée au premier module SAR ADC, pour recevoir le premier signal résiduel et configuré pour délivrer par sa sortie un deuxième signal numérique ;
- un deuxième module de rétroaction configuré pour recevoir un deuxième signal résiduel du deuxième module SAR ADC et pour le traiter et le réinjecter à l'entrée du deuxième module SAR ADC ; et
- un module de multiplexage connecté à la sortie du premier module SAR ADC et à la sortie du deuxième module SAR ADC, le module de multiplexage étant configuré pour délivrer le signal de sortie numérique en la borne de sortie.

Le dispositif de conversion analogique-numérique selon l'invention comprend donc deux étages cascadés de conversion analogique-numérique avec registre à approximations successives et mise en forme du bruit, également appelés étages NS-SAR ADC (de l'anglais *Noise-Shaping Successive Approximation Register Analog-to-Digital Converter*), à savoir un premier étage NS-SAR ADC et un deuxième étage NS-SAR ADC, chaque étage NS-SAR ADC comprenant un module SAR ADC et un module de rétroaction respectif pour mettre en forme le bruit de quantification du module SAR ADC. Le bruit de quantification du premier étage NS-SAR ADC, en particulier du premier module SAR ADC, est introduit dans le deuxième étage NS-SAR ADC pour former un SAR ADC à multiples étages de mise en forme du bruit, également appelé MASH (de l'anglais *Multi-Stage Noise Shaping*).

L'homme du métier notera en outre que la mise en forme du bruit est effectuée par une technique de rétroaction d'erreur de telle sorte que le dispositif de conversion analogique-numérique selon l'invention n'utilise aucun amplificateur opérationnel. Il s'agit donc d'une topologie sans amplificateur opérationnel.

En complément facultatif, le module de multiplexage est apte à fonctionner soit dans un premier mode de fonctionnement dans lequel le signal de sortie numérique délivré est le premier signal numérique, soit dans un deuxième mode de fonctionnement dans lequel le signal de sortie numérique délivré est une combinaison des premier et deuxième signaux numériques. Par conséquent, un autre avantage du dispositif de conversion analogique-numérique selon l'invention est de pouvoir être configuré soit en simple étage, soit en multi-étages, pour supporter différentes largeurs de bande et résolutions.

En complément facultatif, chaque module de rétroaction comprend un filtre de deuxième ordre respectif pour filtrer le signal résiduel respectif avant de le réinjecter à l'entrée du module SAR ADC respectif. Par conséquent, un autre avantage du dispositif de conversion analogique-numérique selon l'invention est de fournir une performance de mise en forme du bruit de quatrième ordre, tout en étant aussi stable qu'un convertisseur analogique-numérique de deuxième ordre.

Suivant d'autres aspects avantageux de l'invention, le dispositif de conversion analogique-numérique comprend une ou plusieurs des caractéristiques suivantes, prises isolément ou suivant toutes les combinaisons techniquement possibles :

- le module de multiplexage est configuré pour fonctionner dans un premier mode de fonctionnement dans lequel le signal de sortie numérique délivré est le premier signal numérique ou dans un deuxième mode de fonctionnement dans lequel le signal de sortie numérique délivré est une combinaison des premier et deuxième signaux numériques ;
- le dispositif de conversion comprend en outre un module de sélection pour sélectionner un mode de fonctionnement parmi le premier mode de fonctionnement et le deuxième mode de fonctionnement du module de multiplexage ;
- le premier module de rétroaction comprend un premier filtre pour filtrer le premier signal résiduel avant de le réinjecter à l'entrée du premier module SAR ADC ;

le premier filtre étant de préférence un filtre du deuxième ordre ;
le premier filtre étant encore de préférence un filtre à réponse impulsionnelle finie ;

- le deuxième module de rétroaction comprend un deuxième filtre pour filtrer le deuxième signal résiduel avant de le réinjecter à l'entrée du deuxième module SAR ADC ;

le deuxième filtre étant de préférence un filtre du deuxième ordre ;
le deuxième filtre étant encore de préférence un filtre à réponse impulsionnelle finie ;

- le premier module SAR ADC comprend :

    + un premier convertisseur numérique-analogique avec une entrée et une sortie ;
    + un premier comparateur avec deux entrées et une sortie, une entrée étant reliée à la sortie du premier convertisseur numérique-analogique et l'autre entrée étant adaptée pour recevoir un signal de référence ; et
    + une première unité logique avec registre à approximations successives, connectée à la sortie du premier comparateur, la première unité logique avec registre à approximations successives étant adaptée pour commander le premier convertisseur numérique-analogique ;
    l'entrée du premier convertisseur numérique-analogique formant l'entrée du premier module SAR ADC ;
    la sortie du premier comparateur formant la sortie du premier module SAR ADC ;

- l'entrée du deuxième module SAR ADC est reliée à la sortie du premier convertisseur numérique-analogique ;
- le deuxième module SAR ADC comprend :

+ un deuxième convertisseur numérique-analogique avec une entrée et une sortie ;

+ un deuxième comparateur avec deux entrées et une sortie, une entrée étant connectée à la sortie du deuxième convertisseur numérique-analogique et l'autre entrée étant adaptée pour recevoir un signal de référence ; et

+ une deuxième unité logique avec registre à approximations successives, connectée à la sortie du deuxième comparateur, la deuxième unité logique avec registre à approximations successives étant configurée pour commander le deuxième convertisseur numérique-analogique ;

l'entrée du deuxième convertisseur numérique-analogique formant l'entrée du deuxième module SAR ADC ;

la sortie du deuxième comparateur formant la sortie du deuxième module SAR ADC ; et

- le module de multiplexage comprend une unité logique d'annulation numérique adaptée pour appliquer une première fonction de transfert au premier signal numérique et une deuxième fonction de transfert au deuxième signal numérique, de manière à annuler le premier signal résiduel.

L'invention a également pour objet un capteur électronique comprenant un dispositif de conversion analogique-numérique pour convertir un signal d'entrée analogique en un signal de sortie numérique, le dispositif de conversion analogique-numérique étant tel que défini ci-dessus.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

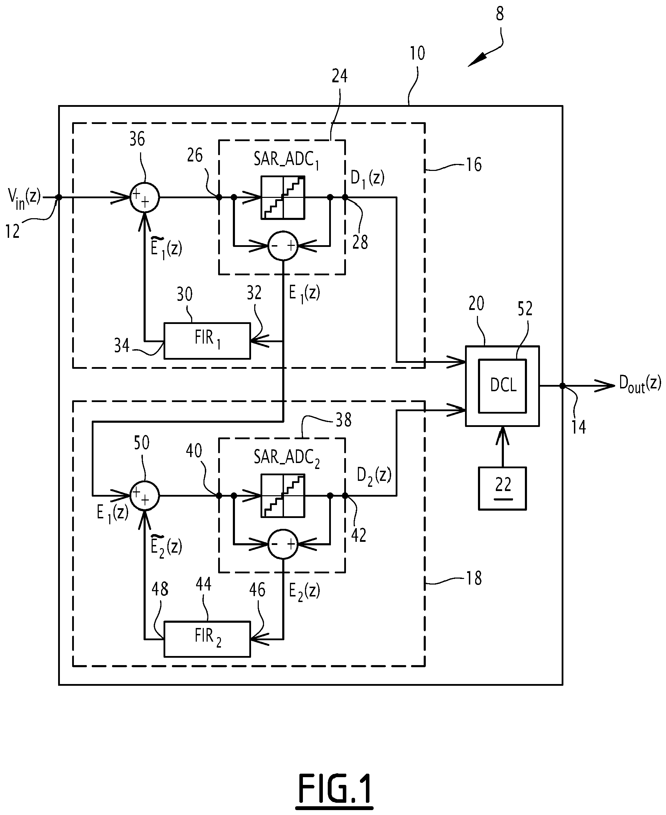

- la figure 1 est une vue schématique d'un capteur électronique comprenant un dispositif de conversion analogique-numérique selon l'invention, le dispositif de conversion comprenant un premier étage NS-SAR ADC et un deuxième étage NS-SAR ADC, le deuxième étage NS-SAR ADC étant connecté en cascade au premier étage NS-SAR ADC, afin de fournir un bruit de quantification du premier étage NS-SAR ADC en entrée du deuxième étage NS-SAR ADC ; cette vue étant en forme d'un schéma bloc, également appelé modèle linéaire ;

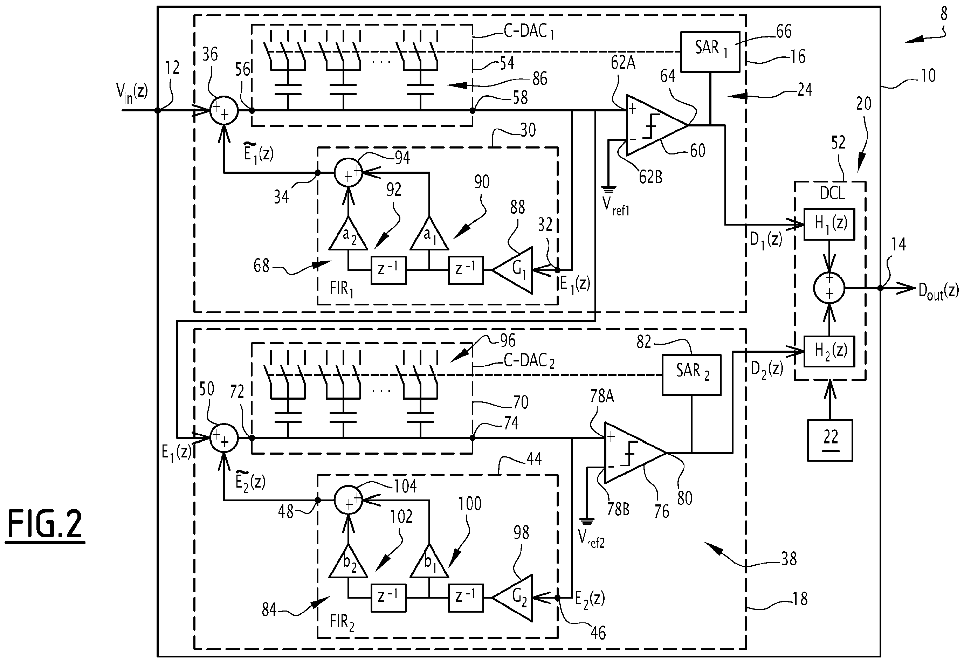

- la figure 2 est une vue similaire à celle de la figure 1, en forme d'un modèle comportemental dans le domaine temporel ;

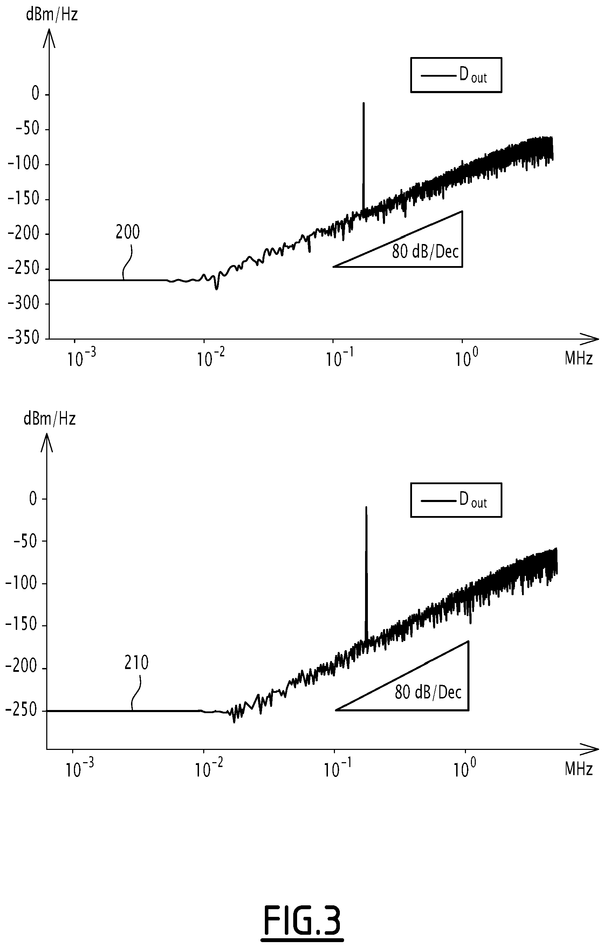

- la figure 3 est un ensemble de deux courbes, chacune représentant une densité spectrale de puissance simulée d'un signal de sortie numérique délivré par le dispositif de conversion analogique-numérique, une première courbe correspondant au modèle linéaire de la figure 1 et une deuxième courbe correspondant au modèle comportemental de la figure 2 ; et

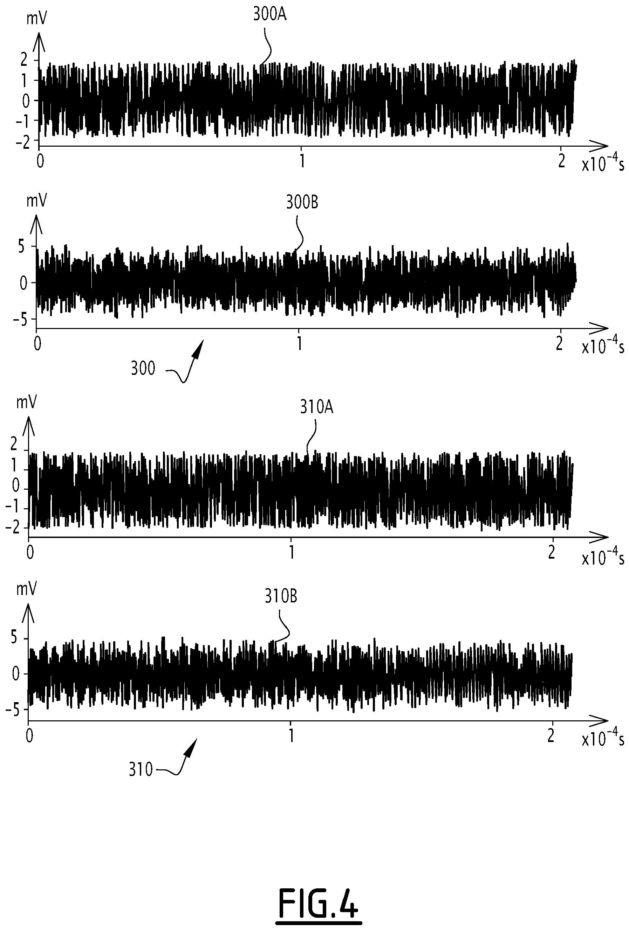

- la figure 4 est un ensemble de deux paires de courbes, chacune représentant un signal d'erreur dans le domaine temporel et respectivement un signal d'erreur filtré pour le deuxième étage NS-SAR ADC, une première paire de courbes correspondant au modèle linéaire de la figure 1 et une deuxième paire de courbes correspondant au modèle comportemental de la figure 2.

Dans la suite de la description, le sigle NS représente la terminologie anglaise « *Noise Shaping* » et signifie alors mise en forme du bruit ; le sigle SAR représente la terminologie anglaise « *Successive Approximation Register* » et signifie alors registre à approximations successives ; et le sigle ADC représente la terminologie anglaise « *Analog-to-Digital Converter* » et signifie alors convertisseur analogique-numérique, ou encore de conversion analogique-numérique. Ainsi, NS-SAR ADC désigne un convertisseur, ou un étage de conversion, analogique-numérique avec registre à approximations successives et mise en forme du bruit.

Sur la figure 1, un capteur électronique 8 comprend un dispositif de conversion analogique-numérique 10 pour convertir un signal d'entrée analogique $V_{in}(z)$ en un signal de sortie numérique $D_{out}(z)$. Le capteur électronique 8 est adapté pour être utilisé dans diverses applications, telles que des applications biomédicales et/ou d'instrumentation.

Le dispositif de conversion analogique-numérique 10 est configuré pour convertir le signal d'entrée analogique $V_{in}(z)$ en signal de sortie numérique $D_{out}(z)$ et comprend une borne d'entrée 12 pour recevoir le signal d'entrée analogique $V_{in}(z)$ et une borne de sortie 14 pour délivrer le signal de sortie numérique $D_{out}(z)$.

Le dispositif de conversion analogique-numérique 10 comprend en outre un premier étage 16 de conversion analogique-numérique avec registre à approximations successives et mise en forme du bruit, également appelé premier étage NS-SAR ADC, et un deuxième étage 18 de conversion analogique-numérique avec registre à approximations successives et mise en forme du bruit, également appelé deuxième étage NS-SAR ADC, le deuxième étage NS-SAR ADC 18 étant connecté de manière cascadée au premier étage NS-SAR ADC 16, et un module de multiplexage 20 connecté respectivement à la sortie du premier étage NS-SAR ADC 16 et à la sortie du deuxième étage NS-SAR ADC 18, le module de multiplexage 20 étant configuré pour délivrer le signal de sortie numérique $D_{out}(z)$ en la borne de sortie 14, ceci à partir d'un premier signal numérique $D_1(z)$ issu du premier étage NS-SAR ADC 16, voire à partir en outre d'un deuxième signal numérique $D_2(z)$ issu du deuxième étage NS-SAR ADC 18.

L'homme du métier comprendra alors que le terme « multiplexage » désigne de manière générale le fait de regrouper sur une voie unique des informations ou des signaux issus de plusieurs voies. Le module de multiplexage 20 doit alors être compris comme un module capable de regrouper en la borne de sortie 14 les signaux issus de plusieurs voies, à savoir les signaux issus des étages NS-SAR ADC 16, 18, le module de multiplexage 20 étant configuré pour délivrer le signal de sortie numérique $D_{out}(z)$ en la borne de sortie 14, ceci à partir d'un premier signal numérique $D_1(z)$ issu du premier étage NS-SAR ADC 16, voire à partir en outre d'un deuxième signal numérique $D_2(z)$ issu du deuxième étage NS-SAR ADC 18, c'est-à-dire à partir de la combinaison du premier signal numérique $D_1(z)$ et du deuxième signal numérique $D_2(z)$.

En complément facultatif, le module de multiplexage 20 est configuré pour fonctionner dans un premier mode de fonctionnement M1 dans lequel le signal de sortie numérique $D_{out}(z)$ délivré est le premier signal numérique $D_1(z)$ ou dans un deuxième mode de fonctionnement M2 dans lequel le signal de sortie numérique $D_{out}(z)$ délivré est une combinaison des premier et deuxième signaux numériques $D_1(z)$ et $D_2(z)$.

Selon ce complément facultatif, le dispositif de conversion 10 comprend en outre un module de sélection 22 configuré pour sélectionner un mode de fonctionnement parmi le premier mode de fonctionnement M1 et le deuxième mode de fonctionnement M2 du module de multiplexage 20.

Le premier étage NS-SAR ADC 16 comprend un premier module 24 de conversion analogique-numérique avec registre à approximations successives, dit premier module SAR ADC 24, également noté $SAR\_ADC_1$, connecté par son entrée 26 à la borne d'entrée 12 et configuré pour délivrer en sa sortie 28 le premier signal numérique $D_1(z)$.

Le premier étage NS-SAR ADC 16 comprend également un premier module de rétroaction 30 configuré pour recevoir en son entrée 32 un premier signal résiduel $E_1(z)$ du premier module SAR ADC 24 et pour le traiter et le réinjecter, via sa sortie 34, à l'entrée 26 du premier module SAR ADC 24.

Dans l'exemple de la figure 1, le premier étage NS-SAR ADC 16 comprend un premier additionneur 36 connecté, d'une part, à la borne d'entrée 12 et à la sortie 34 du premier module de rétroaction 30, et d'autre part, à l'entrée 26 du premier module SAR ADC 24. Le premier additionneur 36 est configuré pour additionner le signal émis par le premier module de rétroaction 30, également noté $\widetilde{E_1}(z)$, au signal d'entrée analogique $V_{in}(z)$ et pour délivrer cette somme de signaux $\widetilde{E_1}(z) + V_{in}(z)$ à l'entrée 26 du premier module SAR ADC 24.

Le deuxième étage NS-SAR ADC 18 comprend un deuxième module 38 de conversion analogique-numérique avec registre à approximations successives, dit deuxième module SAR ADC 38, également noté $SAR\_ADC_2$, connecté par son entrée 40 au premier module SAR ADC 24 pour recevoir le premier signal résiduel $E_1(z)$ et configuré pour délivrer en sa sortie 42 le deuxième signal numérique $D_2(z)$.

Le deuxième étage NS-SAR ADC 18 comprend également un deuxième module de rétroaction 44 configuré pour recevoir en son entrée 46 un deuxième signal résiduel $E_2(z)$ du deuxième module SAR ADC 38 et pour le traiter et le réinjecter, via sa sortie 48, à l'entrée 40 du deuxième module SAR ADC 38.

Dans l'exemple de la figure 1, le deuxième étage NS-SAR ADC 18 comprend un deuxième additionneur 50 connecté, d'une part, au premier étage NS-SAR ADC 16 et à la sortie 48 du deuxième module de rétroaction 44, et d'autre part à l'entrée 40 du deuxième module SAR ADC 38. Le deuxième additionneur 50 est configuré pour additionner le signal émis par le deuxième module de rétroaction 44, également noté $\widetilde{E_2}(z)$, au premier signal résiduel $E_1(z)$ et pour délivrer cette somme de signaux $\widetilde{E_2}(z) + E_1(z)$ à l'entrée 40 du deuxième module SAR ADC 38.

Le module de multiplexage 20 est configuré pour délivrer le signal de sortie numérique $D_{out}(z)$ à partir du premier signal numérique $D_1(z)$, voire en outre du deuxième signal numérique $D_2(z)$. Le module de multiplexage 20 est connecté à la sortie 28 du premier module SAR ADC 24 et à la sortie 42 du deuxième module SAR ADC 38.

Le module de multiplexage 20 est configuré de préférence pour délivrer, comme signal de sortie numérique $D_{out}(z)$ en la borne de sortie 14, soit le premier signal numérique $D_1(z)$, soit la combinaison des premier et deuxième signaux numériques $D_1(z)$ et $D_2(z)$.

Le module de multiplexage 20 comprend une unité logique d'annulation numérique 52, également appelée DCL (de l'anglais *Digital Cancellation Logic*), adaptée pour appliquer une première fonction de transfert $H_1(z)$ au premier signal numérique $D_1(z)$ et une deuxième fonction de transfert $H_2(z)$ au deuxième signal numérique $D_2(z)$, comme le montre la figure 2. L'unité logique d'annulation numérique 52 est adaptée pour annuler le premier signal résiduel $E_1(z)$.

Dans l'exemple de la figure 2, le premier module SAR ADC 24 comprend un premier convertisseur numérique-analogique 54, également noté $C\text{-}DAC_1$, avec une entrée 56 et une sortie 58. L'entrée 56 du premier convertisseur numérique-analogique 54 forme l'entrée 26 du premier module SAR ADC 24.

L'homme du métier observera que l'entrée 56, qui forme l'entrée du premier module SAR ADC 24 dont la fonction est d'effectuer une conversion analogique-numérique, est une entrée du premier convertisseur numérique-analogique 54, mais pas son unique entrée. L'homme du métier comprendra alors que l'entrée 56 est une entrée analogique correspondant à une entrée additionnelle, connue en soi pour un module SAR ADC, dudit convertisseur numérique-analogique 54, et non de l'entrée numérique destinée à recevoir le signal numérique en vue de sa conversion en un signal analogique. L'entrée additionnelle 56 est configurée pour recevoir une tension de référence utilisée pour normaliser ladite entrée numérique. Dans l'exemple de la figure 2, ladite tension de référence correspond au signal délivré par le premier additionneur 36 au premier module SAR ADC 24, i.e. correspond à la somme des signaux

$$\widetilde{E_1}(z) + V_{in}(z).$$

Le premier module SAR ADC 24 comprend également un premier comparateur 60 avec deux entrées 62A, 62B, à savoir une première entrée 62A et une deuxième entrée 62B, et une sortie 64. Une entrée du premier comparateur 60, telle que la première entrée 62A, est reliée à la sortie 58 du premier convertisseur numérique-analogique 54 et l'autre entrée, telle que la deuxième entrée 62B, est adaptée pour recevoir un signal de référence, tel qu'une première tension de référence $V_{ref1}$. La sortie 64 du premier comparateur 60 forme la sortie 28 du premier module SAR ADC 24.

Le premier module SAR ADC 24 comprend en outre une première unité logique avec registre à approximations successives 66, également appelée première unité logique SAR 66 et notée SARi, connectée à la sortie 64 du premier comparateur 60, la première unité logique SAR 66 étant adaptée pour commander le premier convertisseur numérique-analogique 54, comme connu en soi.

Le premier module de rétroaction 30 comprend un premier filtre 68 pour filtrer le premier signal résiduel $E_1(z)$ avant de l'injecter, comme premier signal résiduel filtré $\widetilde{E_1}(z)$, à l'entrée 26 du premier module SAR ADC 24.

Dans l'exemple de la figure 2, le deuxième module SAR ADC 38 comprend un deuxième convertisseur numérique-analogique 70, également noté C-DAC$_2$, avec une entrée 72 et une sortie 74. L'entrée 72 du deuxième convertisseur numérique-analogique 70 forme l'entrée 40 du deuxième module SAR ADC 38.

L'homme du métier observera que l'entrée 72, qui forme l'entrée du deuxième module SAR ADC 58 dont la fonction est d'effectuer une conversion analogique-numérique, est une entrée du deuxième convertisseur numérique-analogique 70, mais pas son unique entrée. L'homme du métier comprendra alors que l'entrée 72 est une entrée analogique correspondant à une entrée additionnelle, connue en soi pour un module SAR ADC, dudit convertisseur numérique-analogique 70, et non de l'entrée numérique destinée à recevoir le signal numérique en vue de sa conversion en un signal analogique. L'entrée additionnelle 72 est configurée pour recevoir une tension de référence utilisée pour normaliser ladite entrée numérique. Dans l'exemple de la figure 2, ladite tension de référence correspond au signal délivré par le deuxième additionneur 50 au deuxième module SAR ADC 38, i.e. correspond à la somme des signaux

$$\widetilde{E_2}(z) + E_1(z).$$

Le deuxième module SAR ADC 38 comprend également un deuxième comparateur 76 avec deux entrées 78A, 78B, à savoir une première entrée 78A et une deuxième entrée 78B, et une sortie 80. Une entrée du deuxième comparateur 76, telle que la première entrée 78A, est reliée à la sortie 74 du deuxième convertisseur numérique-analogique 70, et l'autre entrée du deuxième comparateur 76, telle que la deuxième entrée 78B, est adaptée pour recevoir un signal de référence, tel qu'une deuxième tension de référence $V_{ref2}$. La sortie 80 du deuxième comparateur 76 forme la sortie 42 du deuxième module SAR ADC 38.

Le deuxième module SAR ADC 38 comprend en outre une deuxième unité logique avec registre à approximations successives 82, également appelée deuxième unité logique SAR 82 et notée SAR$_2$, connectée à la sortie 80 du deuxième comparateur 76, la deuxième unité logique SAR 82 étant adaptée pour commander le deuxième convertisseur numérique-analogique 70, comme connu en soi.

Le deuxième module de rétroaction 44 comprend un deuxième filtre 84 pour filtrer le deuxième signal résiduel $E_2(z)$ avant de l'injecter, comme deuxième signal résiduel filtré $\widetilde{E_2}(z)$, à l'entrée 40 du deuxième module SAR ADC 38.

L'unité logique d'annulation numérique 52 est par exemple configurée pour appliquer la première fonction de transfert $H_1(z)$ au premier signal numérique $D_1(z)$ et la deuxième fonction de transfert $H_2(z)$ au deuxième signal numérique $D_2(z)$, selon l'équation suivante :

[Math 1]

$$D_{out}(z) = H_1(z) \cdot D_1(z) + H_2(z) \cdot D_2(z)$$

où $D_{out}$ représente le signal de sortie numérique,
$H_1$ représente la première fonction de transfert,
$D_1$ représente le premier signal numérique,

$H_2$ représente la deuxième fonction de transfert, et

$D_2$ représente le deuxième signal numérique.

Le premier signal numérique $D_1(z)$ vérifie par exemple l'équation suivante :

[Math 2]

$$D_1(z) = STF_1(z) \cdot V_{in}(z) + NTF_1(z) \cdot E_1(z)$$

où $D_1$ représente le premier signal numérique,

$STF_1$ représente une première fonction de transfert de signal,

$V_{in}$ représente le signal d'entrée analogique,

$NTF_1$ représente une première fonction de transfert de bruit, et

$E_1$ représente le premier signal résiduel.

Le deuxième signal numérique $D_2(z)$ vérifie par exemple l'équation suivante :

[Math 3]

$$D_2(z) = STF_2(z) \cdot E_1(z) + NTF_2(z) \cdot E_2(z)$$

où $D_2$ représente le deuxième signal numérique,

$STF_2$ représente une deuxième fonction de transfert de signal,

$E_1$ représente le premier signal résiduel,

$NTF_2$ représente une deuxième fonction de transfert de bruit, et

$E_2$ représente le deuxième signal résiduel.

Selon les équations (1), (2) et (3) mentionnées ci-dessus, le signal de sortie numérique $D_{out}(z)$ vérifie l'équation suivante, écrite de manière condensée :

[Math 4]

$$D_{out}(z) = H_1 \cdot [STF_1 \cdot V_{in}(z) + NTF_1 \cdot E_1(z)] + H_2 \cdot [STF_2 \cdot E_1(z) + NTF_2 \cdot E_2(z)]$$

conduisant ainsi à l'équation suivante, écrite de manière condensée :

[Math 5]

$$D_{out}(z) = H_1 \cdot STF_1 \cdot V_{in}(z) + [H_1 \cdot NTF_1 + H_2 \cdot STF_2] \cdot E_1(z) + H_2 \cdot NTF_2 \cdot E_2(z)$$

Par conséquent, selon l'équation (5), l'équation suivante est vérifiée pour annuler le premier signal résiduel $E_1(z)$, via l'unité logique d'annulation numérique 52 :

[Math 6]

$$H_1(z) \cdot NTF_1(z) + H_2(z) \cdot STF_2(z) = 0$$

Dans l'exemple de la figure 2, le premier convertisseur numérique-analogique 54, noté C-DAC$_1$, contient un premier réseau de condensateurs 86, (de l'anglais *capacitor array*), également appelé premier peigne de condensateurs, connu en soi.

Le premier filtre 68 est de préférence un filtre à réponse impulsionnelle finie, également appelé filtre FIR (de l'anglais *Finite Impulse Response*) et alors noté FIR$_1$.

Le premier filtre 68 est de préférence un filtre du deuxième ordre.

La première fonction de transfert de bruit $NTF_1(z)$ vérifie typiquement l'équation suivante :

[Math 7]

$$NTF_1(z) = 1 - H_{F1}(z)$$

où $NTF_1$ représente la première fonction de transfert de bruit, et
$H_{F1}$ représente une fonction de transfert du premier filtre 68.

Dans l'exemple de la figure 2, le premier filtre 68 est de préférence un filtre FIR de deuxième ordre, connu en soi. Selon cet exemple, le premier filtre 68 comprend une première unité de gain 88 pour appliquer un gain $G_1$ au premier signal résiduel $E_1(z)$ ; une première unité de retard de premier étage 90 avec un gain $a_1$, connectée à la sortie de la première unité de gain 88 ; une première unité de retard de deuxième étage 92 avec un gain $a_2$, connectée à la sortie de la première unité de retard de premier étage 90 ; et un troisième additionneur 94 connecté aux sorties respectives de la première unité de retard de premier étage 90 et de la première unité de retard de deuxième étage 92.
Selon cet exemple, la fonction de transfert du premier filtre 68 vérifie l'équation suivante :

[Math 8]

$$H_{F1}(z) = G_1 \cdot (a_1 z^{-1} + a_2 z^{-2})$$

Une première fonction de transfert de bruit $NTF_1(z)$, idéale pour une mise en forme du bruit de deuxième ordre, vérifie l'équation suivante, qui requiert $G_1 = 2$, $a_1 = 1$ et $a_2 = -0,5$ comme valeurs de paramètre :

[Math 9]

$$NTF_1(z) = (1 - z^{-1})^2$$

Dans l'exemple de la figure 2, le deuxième convertisseur numérique-analogique 70, noté $C\text{-}DAC_2$, contient un deuxième réseau de condensateurs 96, également appelé deuxième peigne de condensateurs, connu en soi.
Le deuxième filtre 84 est de préférence un filtre à réponse impulsionnelle finie, également appelé filtre FIR et alors noté par $FIR_2$.
Le deuxième filtre 84 est de préférence un filtre du deuxième ordre.
La deuxième fonction de transfert de bruit $NTF_2(z)$ vérifie typiquement l'équation suivante :

[Math 10]

$$NTF_2(z) = 1 - H_{F2}(z)$$

où $NTF_2$ représente la deuxième fonction de transfert de bruit, et
$H_{F2}$ représente une fonction de transfert du deuxième filtre 84.

Dans l'exemple de la figure 2, le deuxième filtre 84 est de préférence un filtre FIR de deuxième ordre, connu en soi. Selon cet exemple, le deuxième filtre 84 comprend une deuxième unité de gain 98 pour appliquer un gain $G_2$ au deuxième signal résiduel $E_2(z)$ ; une deuxième unité de retard de premier étage 100 avec un gain $b_1$, connectée à la sortie de la deuxième unité de gain 98 ; une deuxième unité de retard de deuxième étage 102 avec un gain $b_2$, connectée à la sortie de la deuxième unité de retard de premier étage 100 ; et un quatrième additionneur 104 connecté aux sorties respectives de la deuxième unité de retard de premier étage 100 et de la deuxième unité de retard de deuxième étage 102.
Selon cet exemple, la fonction de transfert du deuxième filtre 84 vérifie l'équation suivante :

[Math 11]

$$H_{F2}(z) = G_2 \cdot (b_1 z^{-1} + b_2 z^{-2})$$

Une deuxième fonction de transfert de bruit $NTF_2(z)$, idéale pour une mise en forme du bruit de deuxième ordre, vérifie l'équation suivante, qui requiert $G_2 = 2$, $b_1 = 1$ et $b_2 = -0,5$ comme valeurs de paramètre :

[Math 12]

$$NTF_2(z) = (1 - z^{-1})^2$$

En supposant que les première et deuxième fonctions de transfert de signal $STF_1(z)$, $STF_2(z)$ sont idéales, et vérifient alors l'équation suivante :

[Math 13]

$$STF_1(z) = STF_2(z) = 1$$

et considérant également que la première fonction de transfert $H_1(z)$ vérifie l'équation suivante :

[Math 14]

$$H_1(z) = 1$$

alors les équations (6) et (9) susmentionnées conduisent à l'équation suivante :

[Math 15]

$$H_2(z) = -NTF_1(z) = -(1 - z^{-1})^2$$

Par conséquent, dans cet exemple et conformément aux équations (5), (6) et (12) à (15), le signal de sortie numérique $D_{out}(z)$ vérifie l'équation suivante :

[Math 16]

$$D_{out}(z) = V_{in}(z) - (1 - z^{-1})^4 \cdot E_2(z)$$

Ainsi, l'équation (16) susmentionnée confirme que lorsque chaque module de rétroaction 30, 44 comprend un filtre de deuxième ordre respectif 68, 84 pour filtrer le signal résiduel respectif $E_1(z)$, $E_2(z)$ avant de le réinjecter à l'entrée du module SAR ADC 24, 38 respectif, le dispositif de conversion analogique-numérique 10 selon l'invention fournit une performance de mise en forme de bruit du quatrième ordre.

Le dispositif de conversion analogique-numérique 10 selon l'invention permet donc d'obtenir de meilleurs résultats par rapport aux dispositifs de conversion analogique-numérique de l'état de la technique, comme il sera expliqué ci-après au vu des figures 3 et 4.

La figure 3 est un ensemble de deux courbes 200, 210, à savoir une première courbe 200 et une deuxième courbe 210, chaque courbe 200, 210 représentant une densité spectrale de puissance simulée du signal de sortie numérique $D_{out}$ délivré par le dispositif de conversion analogique-numérique 10, la première courbe 200 correspondant au modèle linéaire de la figure 1 et la deuxième courbe 210 correspondant au modèle de comportement dans le domaine temporel de la figure 2.

La figure 3 montre donc la densité spectrale de puissance du modèle linéaire et du modèle comportemental de l'invention, et montre des résultats similaires pour les deux modèles. La pente de 80 dB/décade de chaque courbe 200, 210 prouve en outre la performance de mise en forme du bruit du quatrième ordre avec le dispositif de conversion analogique-numérique 10 selon l'invention.

La figure 4 est un ensemble de deux paires 300, 310 de courbes, à savoir une première paire 300 et une deuxième paire 310, chaque paire 300, 310 représentant un signal d'erreur dans le domaine temporel et respectivement un signal d'erreur filtré pour le deuxième étage NS-SAR ADC 18. La première paire 300 correspond au modèle linéaire de la figure 1 et la deuxième paire 310 correspond au modèle comportemental dans le domaine temporel de la figure 2.

Sur la figure 4, la première paire 300 comprend une troisième courbe 300A représentant le signal d'erreur dans le domaine temporel et une quatrième courbe 300B représentant le signal d'erreur filtré pour le deuxième étage NS-SAR ADC 18, selon le modèle linéaire de la figure 1. De même, la deuxième paire 310 comprend une cinquième courbe 310A représentant le signal d'erreur dans le domaine temporel et une sixième courbe 310B représentant le signal d'erreur filtré pour le deuxième étage NS-SAR ADC 18, selon le modèle comportemental dans le domaine temporel de la figure 2.

La figure 4 compare donc le signal d'erreur dans le domaine temporel du deuxième étage NS-SAR ADC 18, pour les deux modèles, et montre également comment le filtrage limite cette erreur. Comme cela apparait sur la figure 4, ce filtrage ajoute un peu de bruit au dispositif de conversion analogique-numérique 10, mais il n'est pas significatif et ne remet pas en cause les performances du dispositif de conversion analogique-numérique 10.

Ainsi, le dispositif de conversion analogique-numérique 10 selon l'invention offre plusieurs avantages par rapport aux convertisseurs NS-SAR ADC conventionnels, comme il sera expliqué ci-après.

Premièrement, le dispositif de conversion analogique-numérique 10 selon l'invention permet d'obtenir un ordre plus élevé de mise en forme du bruit en mettant en cascade des étages NS-SAR ADC 16, 18 ayant chacun un ordre plus faible de mise en forme du bruit et sans problème de stabilité.

Ensuite, des composants de circuit supplémentaires ne sont pas nécessaires pour extraire le signal d'erreur du premier étage NS-SAR ADC 16, c'est-à-dire le premier signal résiduel $E_1(z)$, pour le fournir ensuite en entrée du deuxième étage NS-SAR ADC 18. Ainsi, le dispositif de conversion analogique-numérique 10 a une architecture plus simple, car chaque signal d'erreur analogique, c'est-à-dire chaque signal résiduel $E_1(z)$, $E_2(z)$, existe déjà à la fin d'une conversion sur le convertisseur numérique-analogique respectif 54, 70, tel que le peigne 86, 96 respectif de condensateurs. En outre, le signal d'erreur analogique $E_1(z)$ issu du premier convertisseur numérique-analogique 54 est utilisable comme entrée du deuxième étage NS-SAR ADC 18.

Cela rend également le dispositif de conversion analogique-numérique 10 selon l'invention plus précis que certains convertisseurs conventionnels, en raison de la suppression d'une conversion numérique-analogique de la sortie respective 28, 42 du module SAR ADC 24, 38, c'est-à-dire de la sortie du quantificateur (de l'anglais *quantizer*), et également en raison de la suppression d'une étape de soustraction.

En outre, chaque étage NS-SAR ADC 16, 18 fournit un signal numérique, à savoir les premier et deuxième signaux numériques respectifs $D_1(z)$, $D_2(z)$, avec une résolution spécifique, de sorte que le dispositif de conversion analogique-numérique 10 permet de fournir deux résolutions différentes simultanément, à savoir une première résolution correspondant au premier mode de fonctionnement M1 dans lequel le signal de sortie numérique $D_{out}(z)$ délivré est le premier signal numérique $D_1(z)$, et une deuxième résolution correspondant au deuxième mode de fonctionnement M2 dans lequel le signal de sortie numérique $D_{out}(z)$ délivré est une combinaison des premier et deuxième signaux numériques $D_1(z)$, $D_2(z)$, par exemple en sortie de l'unité logique d'annulation numérique 52.

Le dispositif de conversion analogique-numérique 10 selon l'invention offre également une flexibilité pour changer l'ordre de mise en forme du bruit et la résolution en utilisant une combinaison des différents étages NS-SAR ADC 16, 18, notamment de par le module de sélection 22 apte à sélectionner un mode de fonctionnement parmi le premier mode de fonctionnement M1 et le deuxième mode de fonctionnement M2 du module de multiplexage 20. Par conséquent, le dispositif de conversion analogique-numérique 10 offre une architecture de résolution reconfigurable.

De plus, il n'y a aucune restriction sur le type de modules de rétroaction 30, 44, tels que les boucles, les filtres de boucle ou les filtres FIR, dans les étages NS-SAR ADC 16, 18.

De plus, la mise en forme du bruit est effectuée par une technique de rétroaction d'erreur, et le dispositif de conversion analogique-numérique 10 selon l'invention n'utilise pas d'amplificateur opérationnel à transconductance, également appelé OTA (de l'anglais *Operational Transconductance Amplifier*). En d'autres termes, le dispositif de conversion analogique-numérique 10 selon l'invention offre de préférence une topologie sans OTA.

**Revendications**

1. Dispositif de conversion analogique-numérique (10) pour convertir un signal d'entrée analogique ($V_{in}(z)$) en un signal de sortie numérique ($D_{out}(z)$), comprenant :

    - une borne d'entrée (12) pour recevoir le signal d'entrée analogique ($V_{in}(z)$) ;
    - une borne de sortie (14) pour délivrer le signal de sortie numérique ($D_{out}(z)$) ;

- un premier module (24) de conversion analogique-numérique avec registre à approximations successives, dit premier module SAR ADC (24), connecté via son entrée (26) à la borne d'entrée (12) et configuré pour délivrer via sa sortie (28) un premier signal numérique ($D_1(z)$) ;
- un premier module de rétroaction (30) configuré pour recevoir un premier signal résiduel (Ei(z)) du premier module SAR ADC (24) et pour le traiter et le réinjecter à l'entrée (26) du premier module SAR ADC (24) ;

**caractérisé en ce que** le dispositif de conversion (10) comprend en outre :

- un deuxième module (38) de conversion analogique-numérique avec registre à approximations successives, dit deuxième module SAR ADC (38), connecté par son entrée (40) au premier module SAR ADC (24), pour recevoir le premier signal résiduel (Ei(z)) et configuré pour délivrer par sa sortie (42) un deuxième signal numérique ($D_2(z)$) ;
- un deuxième module de rétroaction (44) configuré pour recevoir un deuxième signal résiduel ($E_2(z)$) du deuxième module SAR ADC (38) et pour le traiter et le réinjecter à l'entrée (40) du deuxième module SAR ADC (38) ; et
- un module de multiplexage (20) connecté à la sortie (28) du premier module SAR ADC (24) et à la sortie (42) du deuxième module SAR ADC (38), le module de multiplexage (20) étant configuré pour délivrer le signal de sortie numérique ($D_{out}(z)$) en la borne de sortie (14), et

**en ce que** le premier module de rétroaction (30) comprend un premier filtre (68) pour filtrer le premier signal résiduel (Ei(z)) avant de le réinjecter à l'entrée (26) du premier module SAR ADC (24).

2. Dispositif de conversion (10) selon la revendication 1, dans lequel le module de multiplexage (20) est configuré pour fonctionner dans un premier mode de fonctionnement (M1) dans lequel le signal de sortie numérique délivré ($D_{out}(z)$) est le premier signal numérique ($D_1(z)$) ou dans un deuxième mode de fonctionnement (M2) dans lequel le signal de sortie numérique délivré ($D_{out}(z)$) est une combinaison des premier et deuxième signaux numériques ($D_1(z)$, $D_2(z)$).

3. Dispositif de conversion (10) selon la revendication 2, dans lequel le dispositif de conversion (10) comprend en outre un module de sélection (22) pour sélectionner un mode de fonctionnement parmi le premier mode de fonctionnement (M1) et le deuxième mode de fonctionnement (M2) du module de multiplexage (20).

4. Dispositif de conversion (10) selon l'une quelconque des revendications précédentes, dans lequel le premier filtre (68) est un filtre du deuxième ordre ;
le premier filtre (68) étant de préférence un filtre à réponse impulsionnelle finie ($FIR_1$).

5. Dispositif de conversion (10) selon l'une quelconque des revendications précédentes, dans lequel le deuxième module de rétroaction (44) comprend un deuxième filtre (84) pour filtrer le deuxième signal résiduel ($E_2(z)$) avant de le réinjecter à l'entrée (40) du deuxième module SAR ADC (38) ;
le deuxième filtre (84) étant de préférence un filtre du deuxième ordre ;
le deuxième filtre (84) étant encore de préférence un filtre à réponse impulsionnelle finie ($FIR_2$).

6. Dispositif de conversion (10) selon l'une quelconque des revendications précédentes, dans lequel le premier module SAR ADC (24) comprend :

- un premier convertisseur numérique-analogique (54) avec une entrée (56) et une sortie (58) ;
- un premier comparateur (60) avec deux entrées (62A, 62B) et une sortie (64), une entrée (62A) étant reliée à la sortie (58) du premier convertisseur numérique-analogique (54) et l'autre entrée (62B) étant adaptée pour recevoir un signal de référence ($V_{ref1}$) ; et
- une première unité logique avec registre à approximations successives (66), connectée à la sortie (64) du premier comparateur (60), la première unité logique avec registre à approximations successives (66) étant adaptée pour commander le premier convertisseur numérique-analogique (54) ;

l'entrée (56) du premier convertisseur numérique-analogique (54) formant l'entrée (26) du premier module SAR ADC (24) ;
la sortie (64) du premier comparateur (60) formant la sortie (28) du premier module SAR ADC (24).

7. Dispositif de conversion (10) selon la revendication 6, dans lequel l'entrée (40) du deuxième module SAR ADC (38) est reliée à la sortie (58) du premier convertisseur numérique-analogique (54).

**8.** Dispositif de conversion (10) selon l'une quelconque des revendications précédentes, dans lequel le deuxième module SAR ADC (38) comprend :

- un deuxième convertisseur numérique-analogique (70) avec une entrée (72) et une sortie (74) ;
- un deuxième comparateur (76) avec deux entrées (78A, 78B) et une sortie (80), une entrée (78A) étant connectée à la sortie (74) du deuxième convertisseur numérique-analogique (70) et l'autre entrée (78B) étant adaptée pour recevoir un signal de référence ($V_{ref2}$) ; et
- une deuxième unité logique avec registre à approximations successives (82), connectée à la sortie (80) du deuxième comparateur (76), la deuxième unité logique avec registre à approximations successives (82) étant configurée pour commander le deuxième convertisseur numérique-analogique (70) ;

l'entrée (72) du deuxième convertisseur numérique-analogique (70) formant l'entrée (40) du deuxième module SAR ADC (38) ;
la sortie (80) du deuxième comparateur (76) formant la sortie (42) du deuxième module SAR ADC (38).

**9.** Dispositif de conversion (10) selon l'une quelconque des revendications précédentes, dans lequel le module de multiplexage (20) comprend une unité logique d'annulation numérique (52) adaptée pour appliquer une première fonction de transfert ($H_1(z)$) au premier signal numérique ($D_1(z)$) et une deuxième fonction de transfert ($H_2(z)$) au deuxième signal numérique ($D_2(z)$), de manière à annuler le premier signal résiduel ($Ei(z)$).

**10.** Capteur électronique (8) comprenant un dispositif de conversion analogique-numérique (10) pour convertir un signal d'entrée analogique ($V_{in}(z)$) en un signal de sortie numérique ($D_{out}(z)$), **caractérisé en ce que** le dispositif de conversion (10) est selon l'une quelconque des revendications précédentes.

## FIG.1

FIG.2

## FIG.3

FIG.4

Europäisches
Patentamt

European
Patent Office

Office européen
des brevets

# RAPPORT DE RECHERCHE EUROPEENNE

Numéro de la demande

EP 20 21 6583

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | SONG YAN ET AL: "A 77dB SNDR 12.5MHz Bandwidth 0-1 MASH [sum][Delta] ADC Based on the Pipelined-SAR Structure", 2018 IEEE SYMPOSIUM ON VLSI CIRCUITS, IEEE, 18 juin 2018 (2018-06-18), pages 203-204, XP033427750, DOI: 10.1109/VLSIC.2018.8502382 * figures 1,2 * | 1-10 | INV. H03M3/00 |
| Y | ABHILASH K N ET AL: "A reconfigurable 0-L1-L2 S-MASH2 modulator with high-level sizing and power estimation", 2014 27TH IEEE INTERNATIONAL SYSTEM-ON-CHIP CONFERENCE (SOCC), IEEE, 2 septembre 2014 (2014-09-02), pages 347-352, XP032677692, DOI: 10.1109/SOCC.2014.6948952 * Section IV * | 2,3 | |
| T | Shaolan Li ET AL: "Noise-Shaping SAR ADCs : Advances in Analog Circuit Design 2019" In: "Next-Generation ADCs, High-Performance Power Management, and Technology Considerations for Advanced Integrated Circuits : Advances in Analog Circuit Design 2019", 25 octobre 2019 (2019-10-25), Springer International Publishing, Cham, XP055729094, ISBN: 978-3-030-25267-0 pages 21-40, DOI: 10.1007/978-3-030-25267-0_2, | | **DOMAINES TECHNIQUES RECHERCHES (IPC)**<br><br>H03M |
| X | EP 3 255 798 A1 (MEDIATEK INC [TW]) 13 décembre 2017 (2017-12-13) | 1,4-10 | |
| Y | * alinéas [0035] - [0041] * * figures 4,5A * | 2,3 | |

Le présent rapport a été établi pour toutes les revendications

| Lieu de la recherche | Date d'achèvement de la recherche | Examinateur |
|---|---|---|
| La Haye | 17 mai 2021 | Rocha, Daniel |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&  : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 21 6583

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-05-2021

| Document brevet cité au rapport de recherche | Date de publication | Membre(s) de la famille de brevet(s) | Date de publication |
|---|---|---|---|
| EP 3255798 A1 | 13-12-2017 | CN 107465412 A | 12-12-2017 |
| | | EP 3255798 A1 | 13-12-2017 |
| | | TW 201743565 A | 16-12-2017 |
| | | US 2017353191 A1 | 07-12-2017 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 20180183450 A1

**Littérature non-brevet citée dans la description**

• **M. PACHCHIGAR.** Demystifying High-Performance Multiplexed Data-Acquisition Systems. *Analog Dialogue,* 2014